# EUROPÄISCHE PATENTSCHRIFT

(11) **EP 1 977 455 B1**
(45) Veröffentlichungstag und Bekanntmachung des Hinweises auf die Patenterteilung: **28.07.2010**
(21) Anmeldenummer: 07702590.6
(22) Anmeldetag: 05.01.2007
(51) Int. Cl.: H01L 31/18, H01L 31/20

(54) **VERFAHREN ZUM HERSTELLEN VON SERIELL VERSCHALTETEN SOLARZELLEN SOWIE VORRICHTUNG ZUR DURCHFÜHRUNG DES VERFAHRENS**
METHOD FOR PRODUCING SERIES-CONNECTED SOLAR CELLS AND APPARATUS FOR CARRYING OUT THE METHOD
PROCEDE DE FABRICATION DE CELLULES SOLAIRES CONNECTEES EN SERIE ET DISPOSITIF DE REALISATION DU PROCEDE

(30) Priorität: 27.01.2006 DE 102006004869
(43) Veröffentlichungstag der Anmeldung: 08.10.2008
(73) Patentinhaber: Universität Stuttgart, 70174 Stuttgart (DE)
(72) Erfinder: MERZ, Rainer, 71732 Tamm (DE)
(74) Vertreter: Langöhrig, Angelika Beate
(86) Internationale Anmeldenummer: PCT/EP2007/000052
(87) Internationale Veröffentlichungsnummer: WO 2007/085343

(56) Entgegenhaltungen:
- EP-A- 0 932 207
- US-A- 5 897 332
- US-B1- 6 273 955

## Beschreibung

Die Erfindung betrifft ein Verfahren zum Herstellen von seriell verschalteten Solarzellen, wobei das Verfahren den Schritt des Einbringens eines Substrates in mindestens eine Abscheidekammer sowie das Abscheiden von mindestens einer Materialschicht auf das Substrat oder eine bereits aufgebrachte Materialschicht in der Abscheidekammer umfasst.

Dünnschichtsolarzellen, insbesondere, aber nicht ausschließlich, auf der Basis von amorphem Silizium, bestehen aus einer Reihe von Einzelschichten, nämlich einem Substrat sowie einer hierauf aufgebrachten Rückkontaktschicht, einer aktiven Schicht, inklusive eventueller Pufferschichten oder anderer notwendiger Schichten und einer Frontkontaktschicht. Die Einzelschichten werden nach dem Aufbringen der jeweiligen Schicht, sofern dies erforderlich ist, beispielsweise mittels Laser oder mechanisch strukturiert, um eine Unterteilung in einzelne Schichten zu erhalten, und im Anschluss wird die nächste Schicht aufgebracht. Die Folgeschicht muss dann ebenfalls strukturiert werden. Auf diese Weise ergibt sich für jede abgeschiedene Schicht ein Folgeprozess zur Strukturierung.

Neben dem benötigten zusätzlichen Verfahrensaufwand besitzen die Strukturierungsprozesse verschiedenste Nachteile. So kann die Strukturierung mittels mechanischen Ritzens zur Spanbildung und Rissen in der Schicht führen. Abstehende Späne können gegebenenfalls einen Widerstand zur Zelle bilden oder es kann zu Kurzschlüssen zwischen dem Front- und Rückkontakt kommen.

Bei einer Strukturierung mittels Laser kann aufgrund der Hitzewirkung eine Verschmelzung der Einzelschichten miteinander auftreten. Diese Verschmelzungen führen an den Schnittkanten zu Kurzschlüssen oder Parallelwiderständen zwischen der Front- und Rückkontaktschicht. Weiterhin ist es bekannt, eine Serienverschaltung von Solarzellen auf einfache Weise vorzunehmen, indem die Zellen einschließlich des Substrates getrennt werden und anschließend ein erneutes Verbinden der Frontkontakte mit den Rückkontakten der Folgezelle durch überlappendes Ankleben mit leitfähigem Kleber oder Löten erfolgt. Bei dieser Strukturierung muss das Substrat jedoch leitfähig sein. Je nach Qualität des Klebers und der Verklebung ergibt sich ein zusätzlicher Widerstand.

Darüber hinaus eignen sich die vorgenannten Verfahren nur bedingt zur Herstellung im kontinuierlichen oder quasi-kontinuierlichen Verfahren. Insbesondere müssen die einzelnen Schichten vor der Abscheidung der Folgeschicht strukturiert sein. Bei einer Unterbrechung der Abscheidefolge besteht jedoch die Gefahr, dass die Einzelschichten an der Oberfläche mit der Umgebungsluft reagieren.

Ein weiteres Verfahren zur Strukturierung von verschalteten Solarzellen, insbesondere seriell verschalteten Dünnschichtsolarmodulen, offenbart die DE 196 51 655 C2, bei der vorgesehen ist, dass zumindest die jeweils ersten Halbleiterschichten benachbarter Zellen in ihren angrenzenden Bereichen in einen gemeinsamen Abschnitt übergehen, der aus den ersten Halbleiterschichten umgewandelten isolierenden Materials besteht.

Eine derartige Ausgestaltung und insbesondere das Verschalten auf diese Weise eignen sich jedoch nicht für ein kontinuierliches oder quasi-kontinuierliches Herstellungsverfahren.

Kontinuierliche oder quasi-kontinuierliche Verfahren zur Herstellung von Solarzellen sind aus den US-Patenten US-PS 4,677,738 B1 sowie US-PS 6,258,408 B1 bekannt.

Das Dokument US 6,273,955 B1 beschreibt ein Herstellungsverfahren für Solarzellen.

Ausgehend vom vorgenannten Stand der Technik ist es nun Aufgabe der Erfindung, ein Verfahren sowie eine Vorrichtung zur Herstellung von integriert verschalteten Solarzellenmodulen bereitzustellen, das die elektrischen Nachteile der bisherigen Methoden vermeidet und gleichzeitig ein einfaches Herstellungsverfahren bereitstellt.

Die Erfindung löst diese Aufgabe durch ein gattungsgemäßes Verfahren, bei dem in der Abscheidekammer das Substrat auf eine in Richtung einer Abscheideeinrichtung gewölbte Auflagefläche aufgebracht wird, wobei das Substrat unter mechanischer Vorspannung steht oder entsprechend der Auflagefläche gewölbt ist und eine Strukturierung der aufgebrachten Schicht mittels gespannter Drähte erfolgt, die mit einer definierten Kraft gegen das auf die gewölbte Auflagefläche aufgebrachte Substrat anliegen und die bereits aufgebrachten Materialschichten oder das Substrat abschatten und so die aufzubringende Materialschicht strukturieren.

Bei dem Substrat handelt es sich z. B. um ein flexibles Substrat, das gegen eine gekrümmte Ebene, die in Richtung einer Abscheideeinrichtung gekrümmt ist, anliegt. Gegen diese gekrümmte Auflagefläche zwischen Substrat und Abscheideeinrichtung liegen gleichzeitig die Drähte an, wobei über die gespannten Drähte, die mit der gewölbten Auflagefläche in Kontakt stehen, eine definierte Kraft auf das Substrat aufgebracht werden kann und gleichzeitig eine sichere Auflage über einen vorgegebenen Strukturierungsbereich, gegeben ist. Die gewölbte Fläche ist dabei vorzugsweise zu einer Mittelachse symmetrisch gestaltet und ist insbesondere im Abscheidebereich angeordnet.

Alternativ kann das Substrat auch bereits gemäß der Wölbung der Auflagefläche vorgewölbt sein. In diesem Fall können z. B. auch Metallsubstrate eingesetzt werden.

Durch die bogenförmige Auflage der Substratfolie und die damit definierbare Krafteinstellung und Führung der Drähte, mit der diese auf die Auflagefläche aufliegen, wird eine Strukturierung durch Abschattung bei der Beschichtung der darunter liegenden Schicht erreicht. Es kann auf diese Weise vermieden werden, dass Material unter die Drähte gelangt. Durch die Drähte erfolgt beim Aufbringen der Schicht eine Abschattung der darunter liegenden Materialbahn bzw. des darunter liegenden Substrates. Besonders vorteilhaft ist hierbei, dass kein zusätzlicher separater Strukturierungsschritt vorgesehen werden muss. Die Strukturierung erfolgt zeitgleich mit der Abscheidung in einem Prozess. Die Schichten erfahren nach deren Abscheidung weder mechanische noch thermische Einwirkungen bzw. Belastungen. Auf diese Weise kann ein kontinuierlicher, stationärer, aber auch ein quasi-kontinuierlicher Prozess ermöglicht werden, der eine kostengünstige Produktion von Solarmodulen auf kostensparenden, leichten und flexiblen Substraten ermöglicht.

Die Drähte können dabei in Wölbungsrichtung verlaufen, wobei dies insbesondere bevorzugt ist. Bei stationären Verfahren können die Drähte jedoch auch jede beliebig andere Richtung haben, die zwischen 0° und 90° zur Wölbungsrichtung liegt.

Durch den Wegfall der nachträglichen, mechanischen und thermischen Behandlung erhält eine entsprechende Solarzelle gute elektrische, optische und mechanische Eigenschaften. Parallelwiderstände zwischen Front- und Rückkontakt können nicht entstehen. Der Entstehung von Querwiderständen zwischen den Rückkontakten der Einzelzellen wirken die Reibungskräfte der Abschattungsdrähte auf dem Substrat entgegen.

Insbesondere kann die Plasma Enhanced Chemical Vapour Deposition (PECVD) -Methode zur Abscheidung der Schichten verwendet werden.

Das Verfahren kann stationär, aber auch kontinuierlich oder quasi-kontinuierlich betrieben werden. Dabei ist bei der kontinuierlichen oder quasi-kontinuierlichen Betriebsweise die Bewegungsrichtung des Substrats zugleich die Zugrichtung der gespannten Drähte. Hierdurch richten sich die Drähte automatisch in der gewünschten Weise aus.

Ein kontinuierlicher oder quasi-kontinuierlicher Prozess bietet auch den Vorteil, dass durch die kontinuierliche Bewegung des Substrats durch die Abscheidekammer nur noch eindimensionale Schichtunterschiede auftreten. Diese können sich lediglich über die Breite, also quer zur Zugrichtung, ergeben. In Zugrichtung treten bei konstanten Abscheideparametern keine Schichtunterschiede auf.

Auf die vorstehend beschriebene Weise ist eine Herstellung von integriert verschalteten Dünnschichtzellen auf einem Substrat möglich. Zeitlich auf die Aufwachsphase der Dünnschicht folgende Strukturierungsschritte können entfallen. Die Breite der möglichen herzustellenden Solarzellen hängt von der Breite der Beschichtungsanlage ab. Die Länge der möglichen zu beschichtenden Substrate ist nicht durch die Anlage beschränkt. Die Abscheidekammern können dabei an die aufzubringende Schicht hinsichtlich ihrer Dimensionen angepasst werden.

Nach einem ersten bevorzugten Ausführungsbeispiel kann vorgesehen sein, dass der Draht über eine Spanneinrichtung geführt wird und insbesondere bei der kontinuierlichen Verfahrensführung in oder gegen die Bewegungsrichtung des Substrates bewegt wird. Auf diese Weise kann erreicht werden, dass die Bedeckung der Drähte mit dem abgeschiedenen Material, die in der Abscheidezone auftritt, die Verwendbarkeit des Drahtes nicht beschränkt. Sofern die Drähte gegen die Substratbewegung abgewickelt werden, so steht permanenter Neudraht auf der abzuscheidenden Schicht zur Verfügung. Der Draht kann dabei im Anschluss mechanisch oder chemisch beispielsweise in einem Ätzbad oder über Plasmareinigung zur Wiederverwertung aufbereitet werden.

Dabei kann vorgesehen sein, dass das Substrat über Rollenführungen geführt und gespannt wird. Über derartige Rollenführungen kann besonders einfach eine gute Umlenkung und gleichzeitig Spannung eines flexiblen Materials erfolgen. Darüber hinaus sind derartige Verfahren grundsätzlich im Stand der Technik bekannt, wobei eine Auf- und Abwicklung des anfänglichen Substrats und des fertig beschichteten Substrats bei kontinuierlicher Verfahrensführung auf Wickelwalzen erfolgen kann.

Es kann ebenfalls vorgesehen sein, dass der Draht über eine entsprechende Rollenführung gespannt wird.

Besonders vorteilhaft ist es, wenn mehrere Abscheidekammern nacheinander angeordnet sind, wobei das Substrat die Abscheidekammern nacheinander durchläuft und in jeder Abscheidekammer eine Schicht auf das Substrat bzw. auf eine darunter liegende Schicht abgeschieden wird. Dabei kann vorgesehen sein, dass alle oder lediglich eine der weiteren Abscheidekammern mit einer entsprechenden Strukturierungseinrichtung versehen sind. Derartige Inlineprozesse sind dabei besonders günstig in der Herstellung.

Die Einzelschichten können dabei unmittelbar bei der Erzeugung strukturiert werden und in einem Inlineprozess übereinander abgeschieden werden. Dabei kann vorgesehen sein, dass die Abschattungsdrähte in den einzelnen Kammern versetzt zu den bereits erzeugten Abschattungslinien angeordnet sind, um eine Serienverschaltung zu ermöglichen. Dabei erfolgt der Versatz stets in dieselbe Richtung.

Als Substrat kann insbesondere eine Folie sowie ein Textilmaterial eingesetzt werden.

Als Draht können Metalldrähte, aber auch sonstige Kunststoff- oder Textilfasern, Kohlefasern etc. eingesetzt werden, wobei solche Materialien besonders bevorzugt sind, auf denen die abzuscheidenden Materialien nicht anhaften.

Bei den abzuscheidenden Schichten handelt es sich insbesondere um eine Front- sowie eine Rückkontaktschicht sowie eine dazwischen liegende aktive Schicht, die insbesondere aus einer n-Schicht, eine i-Schicht und einer p-Schicht gebildet sein kann.

Es können auch sogenannte Stapelzellen, also Tandem- oder Triplezellen erzeugt werden.

Die aktive Schicht kann aus Silizium, aber auch Cadmiumtellurid, CIS, CIGS etc. bestehen.

Die Erfindung umfasst des Weiteren eine Vorrichtung zur Durchführung des Verfahrens der vorstehenden Art, umfassend mindestens eine Abscheidekammer, wobei in der Abscheidekammer eine Beschichtungseinrichtung angeordnet ist sowie eine Strukturierungseinheit umfassend mindestens Draht zur Strukturierung einer auf einem Substrat in der Abscheidekammer abzuscheidenen Materialschicht, wobei in der Abscheidekammer eine in Richtung auf die Beschichtungseinrichtung gewölbte Auflagefläche vorgesehen ist und wobei das Substrat ein unter mechanischer Vorspannung stehendes flexibles oder entsprechend der Auflagefläche gewölbtes Substrat ist, und das Substrat auf die Auflagefläche auflegbar ist und der Draht mit definierter Kraft unter einem Winkel von ≥ 0° und < 90° zu einer Wölbungsrichtung der Auflagefläche gegen das Substrat anlegbar ist.

Weitere Vorteile und Merkmale der Erfindung ergeben sich aus den übrigen Anmeldungsunterlagen sowie der nachfolgenden Beschreibung eines Ausführungsbeispiels der Erfindung.

Dabei zeigt die Zeichnung in
- Figur 1: eine Schichtfolge zweier integriert verschalteter Dünnschichtsolarzellen;
- Figur 2: eine Vorrichtung gemäß der Erfindung und
- Figur 3: eine Vorrichtung sowie ein Verfahren zum kontinuierlichen Herstellen von flexiblen Dünnschichtsolarmodulen.

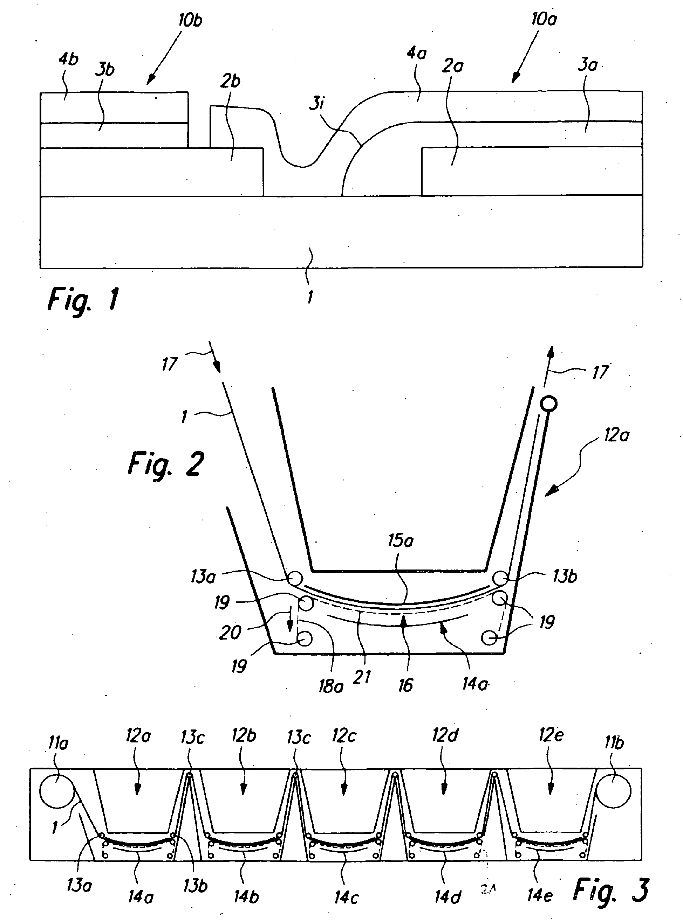

Figur 1 zeigt einen Aufbau einer integriert verschalteten Solarzelle umfassend einen im Wesentlichen vierschichtigen Aufbau. Basis der Solarzelle ist hierbei eine flexible Substratschicht 1, die beispielsweise aus einem Folien- oder Textilmaterial gebildet sein kann. Auf dieser Substratschicht wird zunächst eine sogenannte Rückkontaktschicht abgeschieden, die vorzugsweise dreilagig ist und wobei die Schichtenfolge Chrom/Alu/Zinkoxid sein kann. Statt des Zinkoxids kann auch Zinnoxid oder ITO eingesetzt werden. Die Rückkontaktschicht muss dabei so ausgebildet sein, dass sie nicht durchlaufend auf das Substrat aufgebracht ist, sondern dass die Rückkontaktschichten 2a und 2b der verschiedenen Solarzellen 10a und 10b, die miteinander verschaltet werden sollen, voneinander separiert sind. Hierzu erfolgt, wie nachfolgend beschrieben werden soll, in der vorliegenden Erfindung eine Abschattung mittels Drähten und somit eine Beschichtung in quer zur Transportrichtung separaten Abschnitten. Auf diese Rückkontaktschicht 2a, 2b wird nun eine aktive Schicht aufgebracht, die insbesondere aus Silizium gebildet sein kann, und p-n-Schichten sowie gegebenenfalls Isolierschichten umfasst. Die einzelnen Schichten können dabei auch separat aufgebracht werden.

Die aktive Schicht 3a bzw. 3b der verschiedenen Solarzellenmodule muss dabei ebenfalls voneinander separiert sein. Darüber hinaus darf die aktive Schicht 3a und 3b nicht die gesamte Rückkontaktschicht überdecken. In dem Bereich, in dem die Rückkontaktschicht 2b der Rückkontaktschicht 2a zugewandt ist, um später eine Kontaktierung mittels eines Frontkontaktes 4a zu ermöglichen, muss diese durch die aktive Schicht 3b unbedeckt sein. Als letzte Schicht wird die Frontkontaktschicht 4a aufgebracht, die den Abstand zwischen den Zellen, der durch die Strukturierung zwischen den Rückkontakten aber auch den aktiven Schichten gebildet wird, überbrückt und eine Überlappung mit der Rückkontaktschicht 2b der nächsten Zelle herstellt, um eine serielle Verschaltung der Solarzellen 10a und 10b zu ermöglichen. Die Frontkontaktschicht 4 ist dabei transparent und besteht vorzugsweise aus Zinkoxid (ZnO), Zinndioxid (SnO₂) bzw. ITO.

Dabei ist es wichtig, dass die Strukturierung der Rückkontaktschicht 2 vor der Abscheidung der aktiven Schicht 3 erfolgen muss, da die aktive Schicht 3 gleichzeitig zur Separierung und Isolierung des Rückkontaktes 2a vom Frontkontakt 4a dient, wobei sich hierzu die aktive Schicht 3 im Bereich 3i bis zum Substrat 1 erstreckt, um eine allseitige Isolierung der beiden Kontaktschichten 2, 4 gegeneinander zu erreichen.

Figur 2 zeigt nun ein entsprechendes Verfahren in einem sogenannten Roll-to-Roll-Prozess. Hierbei wird das flexible Substrat 1 auf einer Abwickelrolle 11a, wie sie in Figur 3. gezeigt ist, bereitgestellt und von dieser Abwickelwalze 11a. in eine erste Abscheidekammer 12a eingeführt. Diese erste Kammer, die in Figur 2 vergrößert dargestellt ist, dient der Abscheidung der Rückkontaktschicht 2. Das Substrat 1 wird dabei über Walzen 13a und 13b vorgespannt und über eine konvex in Richtung auf eine Abscheideeinrichtung 14a gewölbte Auflagefläche 15a gespannt und geführt. Im Bereich einer Abscheidezone 16a, die durch den Bereich der Elektrode zum Abscheiden von Schichtmaterial begrenzt wird, wird Schichtmaterial für die Rückschicht 2 auf das Substrat 1 aufgebracht. Um nun die in Figur 1 bereits gezeigte erforderliche Strukturierung der Rückschicht vorzunehmen, ist vorgesehen, parallel zur Transportrichtung des Substrates 1, die mit dem Pfeil 17 gekennzeichnet ist, eine Drahtführung 18a vorzusehen, mittels derer parallel gespannte Drähte, die in Transportrichtung 17 verlaufen, mit definierter Kraft auf die Folie des Substrates 1 aufgedrückt werden und so eine Abschattung unterhalb des Drahtes erfolgt, so dass kein abzuscheidendes Schichtmaterial der Rückschicht in diesem Bereich auf das Substrat 1 aufgebracht wird. Dabei sind entsprechend der Anzahl der vorzusehenden quer zur Transportrichtung 17 verlaufenden Solarzellen 10 eine entsprechende Anzahl Drähte 21 vorzusehen, die die Abschattung vornehmen und so die Rückkontaktschichten 2 der einzelnen Solarzellen 10 voneinander separieren.

Dabei ist vorgesehen, dass zur Spannung des Drahtes 21 ebenfalls Rollen 19 vorgesehen sind, die eine Umlenkung und Spannung des Drahtes 21 sowie eine Aufwicklung desselben vornehmen, da der Draht entgegen der Transportrichtung 17 in die Richtung des Pfeiles 20 transportiert wird, um stets in der Abscheidezone frischen Draht 21 bereitzustellen, auf dem noch keine Materialablagerungen durch das Aufbringen von Material auf das Substrat 1 vorliegen. Sobald der Draht 21 verbraucht ist, kann neuer Draht 21 vorgesehen und der alte Draht 21 der Reinigung und Wiederverwertung zugeführt werden.

Figur 3 zeigt nun einen vollständigen Prozess zur Beschichtung eines Substrats 1, das von einer Abwickelrolle 11a bereitgestellt wird und insgesamt fünf Kammern 12a bis 12e durchläuft und danach auf einer Aufwickelwalze 11b wiederum aufgewickelt wird. Auf der Aufwickelwalze 11b liegen dann vollständig seriell miteinander integriert verschaltete Solarzellen 10 vor. Dabei wird innerhalb jeder Abscheidekammer 12a bis 12e das Substrat 1 über Rollen 13a, die vor der Abscheidezone angeordnet ist, sowie 13b, die nach der Abscheidezone angeordnet ist, gespannt und geführt. Weitere Rollen 13c können zur Umlenkung zwischen den einzelnen Kammern vorgesehen sein. Der gesamte Prozess ist dabei ein geschlossener Prozess, der unter Ausschluss von Umgebungsluft stattfindet.

In jeder der Abscheidekammern 12a bis 12e ist nun eine Abscheideeinrichtung 14a bis 14e vorgesehen, wobei in der ersten Abscheidekammer 12a eine Rückkontaktschicht in der zweiten Abscheidekammer eine n-Schicht, in der dritten Kammer eine i-Schicht und in der vierten Kammer eine p-Schicht aufgebracht wird. Die fünfte Kammer dient zur Aufbringung der Frontkontaktschicht. In jeder der Kammern 12 ist darüber hinaus eine Strukturierung vorgesehen. Dabei müssen die Abschattungsdrähte 21 jeweils nach der Abscheidung des Rückkontaktes 2 im Vergleich zu denen, die nach der Abscheidung der Halbleiterschichten 3 vorgesehen sind, versetzt angeordnet werden, um so zum einen die Isolierung der Rückkontaktschicht 2 mittels der aktiven Schichten 3 gegenüber der Frontkontaktschicht 4 sicherzustellen und nach dem Aufbringen der Frontkontaktschicht 4 zu gewährleisten, dass kein Kontakt der Frontkontaktschicht 4a einer Solarzelle 10a mit der Frontkontaktschicht 4b der nächsten Solarzelle 10b besteht. Lediglich die Abschattungsdrähte 21 beim Aufbringen der drei die aktive Schicht bildenden Schichten in den Abscheidekammern 12b bis 12d verlaufen im Wesentlichen ohne Versatz zueinander. Es kann jedoch auch hier ein geringfügiger Versatz zueinander vorgesehen sein. Dabei erfolgt der Versatz zwischen den einzelnen Abscheidekammern 12 jeweils in dieselbe Richtung, da so die Serienverschaltung erreicht wird.

Über die symmetrisch gewölbte Auflagefläche 15a, die in Richtung der Abscheideeinrichtung gewölbt ist, wird erreicht, dass die Drähte, die der Strukturierung dienen, sich in gewünschter Weise ausrichten, wobei über die Gleitreibung zwischen dem Substrat 1 und der gewölbten Fläche 15 die Ausrichtung begünstigt wird und Querwiderstände zwischen den Rückkontaktschichten 2 vermieden werden.

Auf die vorstehend beschriebene Weise kann besonders einfach und kostengünstig ein sogenannter Roll-to-Roll-Prozess aber auch ein diskontinuierliches Verfahren bereitgestellt werden, mit dem integriert verschaltete Dünnschichtsolarzellen hergestellt werden können.

## Patentansprüche

1. Verfahren zum Herstellen von seriell verschalteten Solarzellen, wobei das Verfahren folgende Schritte umfasst:
Einbringen eines Substrates (1) in mindestens eine Abscheidekammer,
Abscheiden von mindestens einer Materialschicht (2,3,4) auf das Substrat oder eine bereits aufgebrachte Materialschicht in der Abscheidekammer,
**dadurch gekennzeichnet, dass**
in der Abscheidekammer (12) das Substrat auf eine in Richtung einer Abscheideeinrichtung (14) gewölbte Auflagefläche (15) aufgebracht wird, wobei das Substrat flexibel ist und unter mechanischer Vorspannung steht oder entsprechend der Auflagefläche gewölbt ist und
eine Strukturierung der aufgebrachten Schicht mittels mindestens eines gespannten Drahtes (13) erfolgt, der mit einer definierten Kraft gegen das auf die gewölbte Auflagefläche aufgebrachte Substrat anliegt und die aufgebrachte Materialschicht oder das Substrat gegenüber der Abscheideeinrichtung abschattet und so die aufzubringende Materialschicht strukturiert.

2. Verfahren nach Anspruch 1, **dadurch gekennzeichnet, dass** das Verfahren kontinuierlich oder quasi-kontinuierlich abläuft.

3. Verfahren nach Anspruch 1 oder 2, **dadurch gekennzeichnet, dass** der Draht über eine Spanneinrichtung geführt wird und insbesondere bei kontinuierlichen oder quasi-kontinuierlichen Verfahren in oder gegen die Bewegungsrichtung des Substrates bewegt wird.

4. Verfahren nach einem der vorangehenden Ansprüche, **dadurch gekennzeichnet, dass** der mindestens eine Draht unter einem Winkel von ≥ 0° und < 90° zu einer Wölbungsrichtung der Auflagefläche verläuft.

5. Verfahren nach einem der vorangehenden Ansprüche, **dadurch gekennzeichnet, dass** das Substrat über eine Rollenführung geführt und gespannt wird.

6. Verfahren nach einem der vorstehenden Ansprüche, **dadurch gekennzeichnet, dass** der Draht über eine Rollenführung gespannt wird.

7. Verfahren nach einem der vorstehenden Ansprüche, **dadurch gekennzeichnet, dass** mehrere Abscheidekammern nacheinander angeordnet sind und in jeder Abscheidekammer eine Schicht abgeschieden wird.

8. Verfahren nach einem der vorstehenden Ansprüche, **dadurch gekennzeichnet, dass** das Substrat aus einem Folien- oder Textilbahnmaterial gebildet ist.

9. Verfahren nach einem der vorstehenden Ansprüche, **dadurch gekennzeichnet, dass** drei Schichten, nämlich eine Rückkontaktschicht, eine aktive Schicht sowie eine Frontkontaktschicht aufgebracht werden.

10. Verfahren nach Anspruch 9, **dadurch gekennzeichnet, dass** die aktive Schicht einen oder mehrere ladungstrennende Übergänge, insbesondere pn- bzw. pin-Übergänge beinhaltet.

11. Vorrichtung insbesondere zur Durchführung des Verfahrens nach einem der vorangehenden Ansprüche, umfassend mindestens eine Abscheidekammer (12), wobei in der Abscheidekammer (12) eine Beschichtungseinrichtung (14) angeordnet ist sowie eine Strukturierungseinheit (18) umfassend mindestens Draht (13) zur Strukturierung einer auf einem Substrat (1) in der Abscheidekammer (12) abzuscheidenen Materialschicht (2, 3, 4), wobei in der Abscheidekammer (12) eine in Richtung auf die Beschichtungseinrichtung (14) gewölbte Auflagefläche (15) vorgesehen ist und wobei das Substrat (1) ein unter mechanischer Vorspannung stehendes flexibles oder entsprechend der Auflagefläche (15) gewölbtes Substrat (1) ist, und das Substrat (1) auf die Auflagefläche auflegbar ist und der Draht (13) mit definierter Kraft unter einem Winkel von ≥ 0° und < 90° zu einer Wölbungsrichtung der Auflagefläche (15) gegen das Substrat (1) anlegbar ist.

## Claims

1. Method to produce serial-connected solar cells, whereby the method includes the following steps:
- Insertion of a substrate (1) into at least one deposition chamber,
- Deposition of at least one material layer (2, 3, 4) onto the substrate or onto an existing material layer within the deposition chamber,
**characterized in that**
- within the deposition chamber (12), the substrate is deposited onto a support surface (15) arched in the direction of a deposition device (14), whereby the substrate is flexible and is under mechanical tension, or is arched to match the support surface, and
- structuring of the deposited layer is performed by means of at least one tensioned wire (13) that rests against the substrate applied to the arched support surface with a pre-defined force, and that shades the deposited material layer or the substrate from the deposition device, thus structuring the material layer to be deposited.

2. Method as in Claim 1, **characterized in that** the method progresses continuously or quasi-continuously.

3. Method as in Claim 1 or 2, **characterized in that** the wire is fed over a tensioning device and that in particular it is displaced along, or against, the transport direction during continuous or quasi-continuous production.

4. Method as in one of previous claims, **characterized in that** the at least one wire extends at an angle of ≥ 0° and < 90° to an arch direction of the support surface.

5. Method as in one of previous claims, **characterized in that** the substrate is guided and tensioned over a roller assembly.

6. Method as in one of previous claims, **characterized in that** the wire is tensioned over a roller assembly.

7. Method as in one of previous claims, **characterized in that** several deposition chambers are arranged in sequence, and one layer is deposited in each deposition chamber.

8. Method as in one of previous claims, **characterized in that** the substrate is formed of foil or textile-band material.

9. Method as in one of previous claims, **characterized in that** three layers, namely a rear-contact layer, an active layer, and a front-contact layer are deposited.

10. Method as in Claim 9, **characterized in that** the active layer includes one or more charge-separating transitions, particularly pn- or pin-transitions.

11. Apparatus particularly to perform the method as in one of the previous claims, including at least one deposition chamber (12), whereby in the deposition chamber (12) a coating device (14) and a structuring unit (18) are arranged including at least one wire (13) for structuring of a material layer (2, 3, 4) to be deposited on a substrate (1) within the deposition chamber (12), whereby within the deposition chamber (12) a support surface (15) being arched in the direction of the coating device (14) is arranged, and whereby the substrate (1) is a flexible substrate (1) under mechanical tension, or is a substrate (1) arched to match the support surface (15), and the substrate (1) may be overlaid onto the support surface, and the wire (13) may be rested against the substrate (1) with pre-defined force at an angle of ≥ 0° and , < 90° to an arch direction of the support surface (15).

## Revendications

1. Procédé de fabrication de cellules solaires montées en série, le procédé comportant les étapes suivantes :
- introduction d'un substrat (1) dans au moins une chambre de déposition,
- déposition d'au moins une couche de matériau (2, 3, 4) sur le substrat ou sur une couche de matériau déjà déposée dans la chambre de déposition,
**caractérisé en ce que**
dans la chambre de déposition (12), le substrat est déposé sur une surface de pose (15) cintrée vers un dispositif de revêtement (14), le substrat étant flexible et étant mis sous précontrainte mécanique ou le substrat étant cintré conformément à la surface de pose, et
une structuration étant réalisée sur la couche déposée au moyen d'au moins un fil (13) tendu, qui est en appui avec une force définie contre le substrat déposé sur la surface de pose cintrée, et la couche de matériau déposée ou le substrat est circonscrite par rapport au dispositif de revêtement et structure ainsi la couche de matériau à déposer.

2. Procédé selon la revendication 1, **caractérisé en ce que** le procédé se déroule en continu ou quasiment en continu.

3. Procédé selon la revendication 1 ou 2, **caractérisé en ce que** le fil est guidé sur un dispositif de tension et, en particulier dans un procédé en continu ou quasiment en continu, est déplacé dans le sens de déplacement du substrat ou dans le sens opposé.

4. Procédé selon l'une quelconque des revendications précédentes, **caractérisé en ce que** ledit au moins un fil s'étend en formant un angle de ≥ 0° et < 90° par rapport à une direction de courbure de la surface de pose.

5. Procédé selon l'une quelconque des revendications précédentes, **caractérisé en ce que** le substrat est guidé et tendu sur une guidage à rouleaux.

6. Procédé selon l'une quelconque des revendications précédentes, **caractérisé en ce que** le fil est tendu sur un guidage à rouleaux.

7. Procédé selon l'une quelconque des revendications précédentes, **caractérisé en ce que** plusieurs chambres de déposition sont disposées les unes derrière les autres et une couche est déposée dans chaque chambre de déposition.

8. Procédé selon l'une quelconque des revendications précédentes, **caractérisé en ce que** le substrat est formé par un matériau en feuille ou une bande textile.

9. Procédé selon l'une quelconque des revendications précédentes, **caractérisé en ce que** trois couches sont déposées, à savoir une couche de contact arrière, une couche active et une couche de contact avant.

10. Procédé selon la revendication 9, **caractérisé en ce que** la couche active contient une ou plusieurs transitions séparant la charge, en particulier des transitions pn ou pin.

11. Dispositif destiné notamment à la mise en oeuvre du procédé selon l'une quelconque des revendications précédentes, comportant au moins une chambre de déposition (12), un dispositif de revêtement (14) étant disposé dans la chambre de déposition (12), et une unité de structuration (18) comportant au moins un fil (13) pour la structuration d'une couche de matériau (2, 3, 4) à déposer sur un substrat (1) dans la chambre de déposition (12), une surface de pose (15) cintrée vers le dispositif de revêtement (14) étant prévue dans la chambre de déposition (12) et le substrat (1) étant un substrat flexible mis sous précontrainte mécanique ou un substrat cintré conformément à la surface de pose (15), et le substrat (1) peut être déposé sur la surface de pose et le fil (13) peut être mis en appui avec une force définie contre le substrat (1) en formant un angle de ≥ 0° et < 90° par rapport à une direction de courbure de la surface de pose (15).
